# EUROPÄISCHE PATENTSCHRIFT

(11) **EP 1 936 012 B1**
(45) Veröffentlichungstag und Bekanntmachung des Hinweises auf die Patenterteilung: **19.02.2014**
(21) Anmeldenummer: 07123423.1
(22) Anmeldetag: 18.12.2007
(51) Int. Cl.: C30B 15/02, C30B 15/34, C30B 29/06

(54) **Verfahren zum Herstellen kristallisierten Siliciums sowie kristallisiertes Silicium**
Method for manufacturing crystallised silicon and crystallised silicon
Procédé de fabrication de silicium cristallisé et silicium cristallisé

(30) Priorität: 22.12.2006 DE 102006062117
(43) Veröffentlichungstag der Anmeldung: 25.06.2008
(73) Patentinhaber: Fraunhofer Gesellschaft zur Förderung der angewandten Forschung e.V., 80686 München (DE)
(72) Erfinder: Dr. Seidl, Albrecht, 63843 Niedernberg (DE); Dr. Schwirtlich, Ingo, 63897 Miltenberg (DE)

(56) Entgegenhaltungen:
- GB-A- 2 104 410
- US-A- 4 415 401

## Beschreibung

Die Erfindung bezieht sich auf ein Verfahren zum Herstellen kristallisierten Siliciums nach dem EFG-Prozess unter Verwendung eines Formgebungsteils, zwischen dem und einer Siliciumschmelze kristallisiertes Silicium in einer Ziehzone wächst, wobei der Siliciumschmelze und/oder der Ziehzone ein Inertgas und zumindest Wasserdampf zugeführt wird, durch das der Sauerstoffgehalt in dem kristallisierten Silicium erhöht wird. Ferner nimmt die Erfindung auf kristallisiertes Silicium Bezug, das nach dem EFG-Verfahren hergestellt ist und Wasserstoff, Kohlenstoff und Sauerstoff enthält.

Silicium aus dem EFG (Edge-defined Film-fed Growth)-Prozess ist ein unter Verwendung eines Kapillarspalts als Formgeber für die Schmelze in Form von dünnwandigen Bändern oder polygonalen oder zylindrischen dünnwandigen Rohren kristallisiertes Silicium. Das entsprechende Verfahren und Ausgestaltungen dieses sind zum Beispiel in der US-A-5,098,229 oder der US-B-6,562,132 sowie den in diesen zitierten Dokumenten beschrieben.

Bei der Herstellung des kristallisierten Siliciums nach dem EFG-Verfahren erfolgt das Ziehen des Siliciums in einem nach oben hin offenen Rezipienten mit darin enthaltenen Ofeneinbauten, Umlenkeinrichtungen und insbesondere einem Schmelztiegel zur Aufnahme der Siliciumschmelze. Dabei wird unabhängig von der konkreten Ausführungsform der Rezipient kontinuierlich unter Normaldruck mit einem Inertgas wie Argon durchströmt. Durch diese Maßnahmen kann der Eintritt von Luft bzw. Sauerstoff in den Rezipienten und die damit verbundene Oxidation der Siliciumschmelze, der in dem Rezipienten vorhandenen heißen Graphitteile sowie des kristallisierten Siliciums wie Siliciumband bzw. Siliciumrohr unterbunden bzw. minimiert werden.

Ausschlaggebend für die Herstellung kristallisierten Siliciums hoher Güte ist beim EFG-Verfahren unter anderem, dass die Höhe der Siliciumschmelze, also des Schmelzbades möglichst stabil gehalten wird, um die thermischen Bedingungen im Kristallisationsbereich, also in dem Bereich zwischen dem Formgebungsteil und der Siliciumschmelze stabil zu halten. Dies wird dadurch sichergestellt, dass ein kontinuierliches geregeltes Nachchargieren von förder- und dosierfähigem Siliciumgranulat in den Schmelztiegel hinein erfolgt. Regelung bedeutet dabei, dass die Masse des nachzuchargierenden Siliciumgranulats der Masse entspricht, die die Schmelze durch das Wachstum des kristallisierten Siliciums, also des Bandes bzw. Rohres verlässt.

Entsprechendes kristallisiertes Silicium wird im erheblichen Umfang für Solarzellen benutzt. Dabei ist für die fotovoltaischen Eigenschaften des Siliciums aus dem EFG-Prozess von Bedeutung, dass sich die Schmelze in einem Graphittiegel befindet und nicht zum Beispiel in einem Quarzglastiegel bzw. in einem oxidkeramischen Tiegel, wie dies bei anderen Verfahren der Fall ist, wie zum Beispiel beim Kristallisationsverfahren nach Czochralski, nach dem ein massiver Kristall aus einer Schmelze gezogen wird, oder bei der gerichteten Erstarrung einer Schmelze im Tiegel.

Beim EFG-Verfahren befindet sich die Schmelze nicht im direkten Kontakt mit oxidischem Material, sondern ausschließlich mit Graphit, der im Kontaktbereich zur Siliciumschmelze zu Siliciumcarbid reagiert. Hierdurch bedingt liegt der Kohlenstoffgehalt der Schmelze beim EFG-Prozess zwangsläufig in der Größenordnung der Löslichkeit von Kohlenstoff in der Siliciumschmelze, bestimmt durch das Phasendiagramm Silicium-Siliciumcarbid sowie die Temperatur, während der Sauerstoffgehalt vergleichsweise gering ist und typischerweise unter 5x10¹⁵ cm⁻³ und somit ca. zwei Größenordnungen unter dem Niveau von Silicium, das nach einem der zuvor genannten anderen Kristallisationsprozesse hergestellt wird.

Aus der US-A-4,415,401 (DE-C-31 09 059) und verschiedenen Nachveröffentlichungen wie "B. Mackintosh, J.P. Kalejs, C.T. Ho., F.V. Wald; Multiple EFG silicon ribbon technology as the basis for manufacturing low-cost terrestrial solar cells; Proc. 3rd ECPVSEC, Cannes 1980, 553", "J.P. Kalejs, L.-Y. Chin; Modeling of ambientmeniscus melt interactions associated with carbon and oxygen transport in EFG of silicon ribbon; J. Electrochem Soc. 129 (1982) 1356"; "B. Pivac, V. Borjanovic, I. Kovacevic, B.N. Evtody, E.A. Katz; Comparative studies of EFG poly-Si grown by different procedures; Solar Energy Mat. & Solar Cells 72 (2002) 165" ist es bekannt, dass der Sauerstoffgehalt zuvor nach dem EFG-Verfahren hergestellten Siliciums durch kontrolliertes Einmischen von Kohlenmonoxid oder Kohlendioxid in das Inertgas bis über 1x10¹⁷ cm⁻³ erhöht werden kann und dass damit eine signifikante Erhöhung der mittleren Minoritätsladungsträgerlebensdauer bzw. der mit entsprechenden Solarzellen erreichbaren Wirkungsgrade erreicht werden kann.

Die Zugabe einer kohlenstoffhaltigen Sauerstoffquelle wie CO oder CO₂ (US-A-4,415,401) wird gegenüber der Zugabe von Luft bzw. Sauerstoff deswegen favorisiert, weil ein erhöhter Sauerstoffgehalt in der Rezipienten-Atmosphäre primär zu verstärktem Abbrand der graphitischen Bauteile und damit zur beschleunigten Zerstörung dieser führt. Erst durch eine entsprechende Reaktion wird bei der Verwendung von Luft bzw. Sauerstoff das benötigte Kohlenmonoxid gebildet, welches nach der US-A-4,415,401 mit der Siliciumschmelze zu Siliciumcarbid reagiert. Dabei geht der Sauerstoff in die Schmelze in Lösung. Eine direkte Zugabe von Kohlenmonoxid bzw. Kohlendioxid verringert somit den Abbrand der Ofeneinbauteile bei ansonsten gleichem Effekt. Unter Berücksichtigung dieser Überlegungen wird nach den vorbekannten Veröffentlichungen Silicium beim EFG-Verfahren mit erhöhtem Sauerstoffgehalt mittels Zumischung von Kohlenmonoxid hergestellt. Nachteilig bei den entsprechenden Verfahren ist jedoch, dass gleichzeitig mit der Erhöhung der Sauerstoffkonzentration der Anteil von Siliciumcarbid bzw. Kohlenstoff in der Schmelze zunimmt, wodurch sich Eigenschaften des kristallisierten Siliciums insbesondere bei der Verwendung in Solarzellen verschlechtern können.

Nach der US-A-4,415,401 (DE-A-31 09 051) soll der Schmelzzone Inertgas höchsten verfügbaren Reinheitsgrades zugeführt werden. Gegebenenfalls kann Wasserdampf als Verunreinigung bis maximal 10 bis 25 ppm enthalten sein.

Die DE-B-1 291 322 bezieht sich auf ein Verfahren zum Ziehen eines Zonen unterschiedlicher Dotierung aufweisenden Halbleiterkristalls. Um die unterschiedlich dotierten Zonen zu erzielen, wird ein oxidierender Gasstrom eingesetzt.

Nach der JP-A-05 279 187 können nach dem EFG-Verfahren TiO₂-Einkristalle gezogen werden. Einem eine Schmelzzone umspülenden Sauerstoff enthaltenden Inertgas kann H₂O mit einem Anteil von 1 % beigemischt werden, um eine Stabilisierung der Kristallstruktur zu erreichen.

Die Literaturstelle Pivac, B; Borjanovic, V; Kovacevic, I; Evtody, B N; Katz, E A; "Comparative studies of EFG poly-Si grown by different procedures", Solar Energy Mat. & Solar Cells 72 (202), Seiten 165 - 171, setzt sich mit Verunreinigungen im polykristallinen Silicium auseinander und zwar in Abhängigkeit von zur Anwendung gelangenden Herstellungsverfahren, zu denen das Czochralski-Verfahren, das Float Zone (FZ) -Verfahren und das EFG-Verfahren gehören.

In der Literaturstelle Kalejs, JP: "Point defect, carbon and oxygen complexing in polycristalline silicon", Journal of Crystal Growth 128 (1993), Seiten 298 - 303, wird die aus dem Bereich der Kristallisation von monokristallinem, versetzungsfreiem Silicium nach dem Czochralski-Verfahren und nach dem Float Zone (FZ) -Verfahren bekannte Theorie der Punkteffektentstehung in Abhängigkeit des Verhältnisses von Wachstumsgeschwindigkeit zum Temperaturgradient auf EFG-Verhältnisse übertragen.

Die EP-A-0 54 656 bezieht sich auf ein Verfahren zum tiegelfreien Zonenschmelzen.

Gegenstand der DE-C-33 17 954 ist ein Halbleiterbauelement mit einer Halbleiterschicht aus einem polykristallinen Siliciumfilm.

Der vorliegenden Erfindung liegt die Aufgabe zugrunde, ein Verfahren sowie ein kristallisiertes Silicium der eingangs genannten Art so weiterzubilden, dass eine Erhöhung des Sauerstoffgehalts erreichbar ist, ohne dass zwingend entsprechend der Kohlenstoffgehalt zunehmen muss.

Erfindungsgemäß wird die Aufgabe durch ein Verfahren zuvor beschriebener Art dadurch gelöst, dass dem Inertgas 50 ppm bis 250 ppm Wasserdampf zugemischt wird, wobei das Inertgas einen Gehalt an Sauerstoff, CO und/oder CO₂ von insgesamt weniger als 20 ppm enthält.

Überraschenderweise hat sich gezeigt, dass sich durch Zumischung von reinem Wasserdampf zum Inertgas wie Argon eine signifikante Erhöhung der Sauerstoffkonzentration in der Schmelze bzw. im kristallisierten Silicium erreichen lässt, ohne eine erhöhte Oxidation der Graphitteile und ohne eine erhöhte Bildung von Siliciumcarbid auf der Schmelze. Es konnte festgestellt werden, dass mit dem vom Wasserdampfgehalt des Inertgases abhängigen Sauerstoffgehalt des kristallisierten Siliciums kein verstärktes Wachstum von Siliciumcarbid einhergeht. Auch bei höchsten erreichten Sauerstoffkonzentrationen liegt zwar der Kohlenstoffgehalt im kristallisierten Silicium nach wie vor über der Löslichkeit, muss also teilweise in Form von Ausscheidungen vorliegen, ist jedoch mikroskopisch nicht beobachtbar. Silicium mit derart erhöhtem Sauerstoffgehalt bei gleichzeitig submikroskopisch feinst verteilten Kohlenstoff enthaltenden Ausscheidungen zeigt signifikant verbesserte fotovoltaische Eigenschaften. Durch den Gehalt an Sauerstoff, CO und/oder CO₂ von insgesamt weniger als 20 ppm in dem Inertgas werden unerwünschte Kohlenstoff- bzw. Siliciumcarbidkonzentrationen in dem kristallisierten Silicium vermieden.

Das kontrollierte Zumischen von Wasserdampf kann mittels eines Massendurchflussmessers erfolgen, der aus einer den Wasserdampf erzeugenden Dampfzelle gespeist wird. Hierbei ergibt sich der gewünschte Wasserdampfgehalt im Inertgas aus dem Verhältnis des eingestellten Wasserdampfdurchflusses und unabhängig davon zu messendem Inertgasdurchfluss.

Eine andere Möglichkeit besteht darin, mittels eines Feuchtemessgerätes den Wasserdampfgehalt am Einlass des Inertgases in den Rezipienten kontinuierlich oder zeitweise zu messen und über ein Regelventil die Wasserdampfeinmischung zu regeln.

Eine weitere Möglichkeit sieht vor, dass über eine wasser- bzw. wasserdampfdurchlässige Membran definiert Wasserdampf aus einem Reservoir mit bekanntem Wassergehalt (zum Beispiel reines Wasser) in das Inertgas diffundiert.

Nach einem weiter hervorzuhebenden Vorschlag der Erfindung ist vorgesehen, dass chlorhaltiges Siliciumgranulat mit einem Chlorgehalt zwischen 1 ppmw (parts per million per weight) und 50 ppmw zur Bildung der oder von Siliciumschmelze aufgeschmolzen wird. Besonders gute Resultate werden bei Verwendung von Granulat mit einem Chlorgehalt bei 10 ppmw erzielt. Das chlorhaltige Siliciumgranulat kann gegebenenfalls allein zum Nachchargieren verwendet werden.

Dabei sollte das Granulat kugelförmige Gestalt mit einem Kugeldurchmesser zwischen 0,5 mm und 5 mm aufgeschmolzen werden, wobei insbesondere 90 % des Granulats eine Kugeldurchmesserverteilung zwischen 0,8 mm und 3 mm aufweisen sollte. Das entsprechende Granulat kann aus einem Wirbelschichtverfahren (fluidized bed reactor) unter Verwendung von Trichlorsilan oder anderen Chlorsilanen hergestellt werden. Ebenfalls geeignet ist mechanisch klein gebrochenes Siliciumgranulat, das von grobstückigem Silicium aus einem Siemensprozess ebenfalls unter Verwendung von Trichlorsilan oder anderen Chlorsilanen hergestellt wird, wobei die Siebkorngrößenverteilung zwischen mesh 0,5 und mesh 5 liegen sollte, vorzugsweise zu 90 % zwischen mesh 1 und mesh 3. Entsprechendes Silicium mit geeignetem Chlorgehalt kann entsprechend der Lehre der US-A-5,077,028 hergestellt werden. Die zuvor angegebene ideale Korngrößenverteilung ermöglicht ein ausreichend schnelles Aufschmelzen beim EFG-Prozess innerhalb weniger Sekunden. Dies ist erforderlich, um das enthaltene Chlor in ausreichender Menge der Siliciumschmelze zuzuführen.

Die Erfindung zeichnet sich auch durch ein kristallisiertes Silicium, das nach dem EFG-Verfahren hergestellt ist, insbesondere nach den zuvor erläuterten Verfahrensmaßnahmen dadurch aus, dass das kristallisierte Silicium einen Gesamtkohlenstoffgehalt C_{C} und einen Gesamtsauerstoffgehalt C_{O} im Verhältnis 1/50 ≤ C_{O}/C_{C} ≤ 1/500 sowie einen Chlorgehalt C_{Cl} mit 5x10¹⁵ cm⁻³ ≤ C_{CL} ≤ 1x10¹⁷ cm⁻³ aufweist. Insbesondere ist vorgesehen, dass sich C_{C} zu C_{O} verhält wie in etwa 100:1. Dabei liegt der Sauerstoff in dem kristallisierten Silicium im Wesentlich gelöst vor. Ferner sollte der Kohlenstoff bis zu einem Kohlenstoffgehalt von in etwa 8x10¹⁷ cm⁻³ in Übersättigung gelöst vorliegen.

Insbesondere ist vorgesehen, dass der Sauerstoffgehalt C_{O} beträgt 8x10¹⁵ Atome/cm³ ≤ C_{O} ≤ 4x10¹⁶ Atome/cm³ und der Kohlenstoffgehalt beträgt 5x10¹⁷ Atome/cm³ ≤ C_{C} ≤ 3x10¹⁸. Vorzugsweise beträgt die Sauerstoffgehalt in etwa 2x10¹⁶ Atome/cm³ und/oder die Kohlenstoffgehalt C_{C} in etwa 2x10¹⁸ Atome/cm³.

Somit ist Gegenstand der Erfindung ein nach dem EFG-Verfahren hergestelltes Silicium, bei dem das Verhältnis des Gesamt-Kohlenstoffgehalts im Silicium, der zum Beispiel mittels Verbrennungsanalyse bestimmt wird, zum Sauerstoffgehalt, der mittels FTIR ermittelt werden kann, zwischen 50 und 500 liegt. Der absolute Sauerstoffgehalt im Silicium sollte dabei zwischen 8x10¹⁵ Atome/cm³ und 4x10¹⁶ Atome/cm³ liegen. Die Größe der Kohlenstoff enthaltenden Ausscheidungen wie zum Beispiel Siliciumcarbid sollte gering gehalten werden. Dies wird insbesondere durch die Verwendung von Wasserdampf erreicht. Erfindungsgemäß sollte der absolute Kohlenstoffgehalt, der durch eine Verbrennungsanalyse bestimmt wird, zwischen 5x10¹⁷ Atome/cm³ und 3x10¹⁸ A-tome/cm³ liegen. Ferner zeichnet sich das kristallisierte Silicium dadurch aus, dass die Größe der Ausscheidung zu mindestens 90 % unter 50 nm liegt.

Insbesondere bei der Verwendung in Solarzellen zur Erzielung guter fotovoltaischer Eigenschaften sollte das Verhältnis Kohlenstoff zu Sauerstoff 100:1 betragen, wobei der Sauerstoffgehalt bei 2x10¹⁶ Atome/cm³ und der Kohlenstoffgehalt 2x10¹⁸ cm³ betragen bzw. in diesem Bereich liegen sollte.

Die Wirkung des Sauerstoffs liegt darin, Getterzentren für metallische Verunreinigungen zu bilden. Darüber hinaus ist davon auszugehen, dass die submikroskopischen Kohlenstoff enthaltenden Ausscheidungen eine zusätzliche ähnliche getternde Wirkung haben. So wird in der Literatur davon ausgegangen, dass Siliciumcarbid-Ausscheidungen in Silicium-Metalle gettern könnten. Das erfindungsgemäße kristallisierte Silicium aus dem EFG-Prozess kombiniert folglich beide Eigenschaften.

Eine weitere Wirkung des in die Inertgasatmosphäre des Rezipienten kontrolliert eingebrachten Wasserdampfs dürfte darin bestehen, dass bei der Zersetzung des Wassers an den heißen Oberflächen der Einbauten auch Wasserstoff frei wird. Dieser Wasserstoff diffundiert in die Siliciumschmelze und auch in das erstarrende Silicium und verbleibt dort wegen der EFG-typischen schnellen Abkühlung des Siliciums, also des Siliciumrohres bzw. -bandes entlang eines EFG-typischen axialen Temperaturgradienten, der in der Region direkt oberhalb des Erstarrungsbereichs zwischen 200 K/cm und 400 K/cm, bevorzugt bei 300 K/cm liegt. Wasserstoff wirkt bei der Herstellung von Solarzellen passivierend. Dabei liegt abweichend von vorbekannten Vorschlägen, bei der der Wasserstoff erst während des Solarzellenprozesses zugesetzt wird, entsprechend der erfindungsgemäßen Lehre der Wasserstoff bereits im kristallisierten Silicium, also im unprozessierten Siliciumwafer vor.

Der Wasserstoff wird bevorzugt zu den Spannungsfeldern im Umfeld von Gitterstörungen wie zum Beispiel, Versetzungen, Versetzungsclustern, Kleinwinkelkorngrenzen und Korngrenzen diffundieren und sich dort an freien Grenzflächenbindungen festmachen, worauf ein Großteil der passivierenden Wirkung beruht. Im Fall von Silicium aus dem EFG-Prozess ist auch von Bedeutung, dass ein Teil des im Silicium vorliegenden Kohlenstoffs entlang der vielen EFG-typischen Zwillingskomgrenzen in Form von SiC-Lagen in das Siliciumgitter eingebaut wird und dieses dort verspannt. Auch metallische Verunreinigungen diffundieren bevorzugt zu derartig verspannten Gitterbereichen, in denen erstere durch den erfindungsgemäß schon bei der Kristallisation vorliegenden Wasserstoff in-situ passiviert werden können.

Dabei hat sich überraschenderweise gezeigt, dass der Effekt durch das Nachchargieren von chlorhaltigem Siliciumgranulat gegenüber dem Nachchargieren von Siliciumgranulat geringeren Chlorgehalts besonders ausgeprägt ist, d. h. bei gleichem (erhöhtem) Sauerstoffgehalt und gleich fein verteiltem Kohlenstoff durch einen gleichzeitig erhöhten Chlorgehalt erfolgt eine weitere Verbesserung der fotovoltaischen Eigenschaften.

Somit zeichnet sich das kristallisierte Silicium ferner dadurch aus, dass zusätzlich zu den erfindungsgemäßen Gehalten an Sauerstoff und fein verteiltem Kohlenstoff Chlor in einer Konzentration C_{Cl} zwischen 5x10¹⁵ Atome/cm³ und 1x10¹⁷ Atome/cm³ vorliegt. Besonders gute Resultate ergeben sich bei einem Chlorgehalt von in etwa 5x10¹⁶ Atome/cm³.

In Ausgestaltung ist vorgesehen, dass chlorhaltiges Siliciumgranulat mit einem Chlorgehalt zwischen 1 ppmw und 50 ppmw, vorzugsweise in etwa 10 ppmw zur Bildung der oder von Siliciumschmelze aufgeschmolzen wird.

Die Wirkung des Chlors wird einerseits in einer weiteren Getterwirkung bezüglich metallischer Verunreinigung gesehen, andererseits kann davon ausgegangen werden, dass die Konzentration von metallischen Verunreinigungen insgesamt über das Abdampfen von flüchtigen Metallchloriden aus der Schmelze vermindert wird.

Bevorzugterweise wird Granulat kugelförmiger Gestalt mit einer Kugeldurchmesserverteilung zwischen 0,5 mm und 5 mm aufgeschmolzen. Dabei sollte Granulat kugelförmiger Gestalt aufgeschmolzen werden, bei dem in etwa 90 % eine Kugeldurchmesserverteilung zwischen 0,8 mm und 3 mm aufweisen.

Aus den erfindungsgemäßen kristallisierten Siliciumbändern bzw. -rohren können vorzugsweise durch Laserschneiden Wafer ausgeschnitten werden, wie dies in der US-B-6,376,797 oder der US-B-6,423,928 beschrieben ist. Entsprechende Wafer aus dem erfindungsgemäß hergestellten Silicium können entweder ohne weitere Behandlung oder nach einem leichten nasschemischen Abätzen von zum Beispiel 1 µm bis 20 µm Tiefe zur Herstellung von Solarzellen mit erhöhtem Wirkungsgrad verwendet werden. Durch das Abätzen können gezielt oberflächennahe gegetterte metallische Verunreinigungen entfernt werden.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden Ausführungsbeispielen.

Es zeigen:
- Fig. 1: eine Prinzipdarstellung einer Anordnung zum Herstellen von Silizium nach dem EFG-Prozess,
- Fig. 2: eine Prinzipdarstellung zur Erläuterung des erfindungsgemäßen Verfahrens,
- Fig. 3: eine erste Ausführungsform zum Beimischen von Wasserdampf,
- Fig. 4: eine zweite Ausführungsform zum Beimischen von Wasserdampf,
- Fig. 5: eine dritte Ausführungsform zum Beimischen von Wasserdampf,
- Fig. 6: Darstellungen bezüglich der Änderung des Wirkungsgrades von Solarzelle und
- Fig. 7: Darstellungen der internen Quanteneffizienz bei Solarzellen.

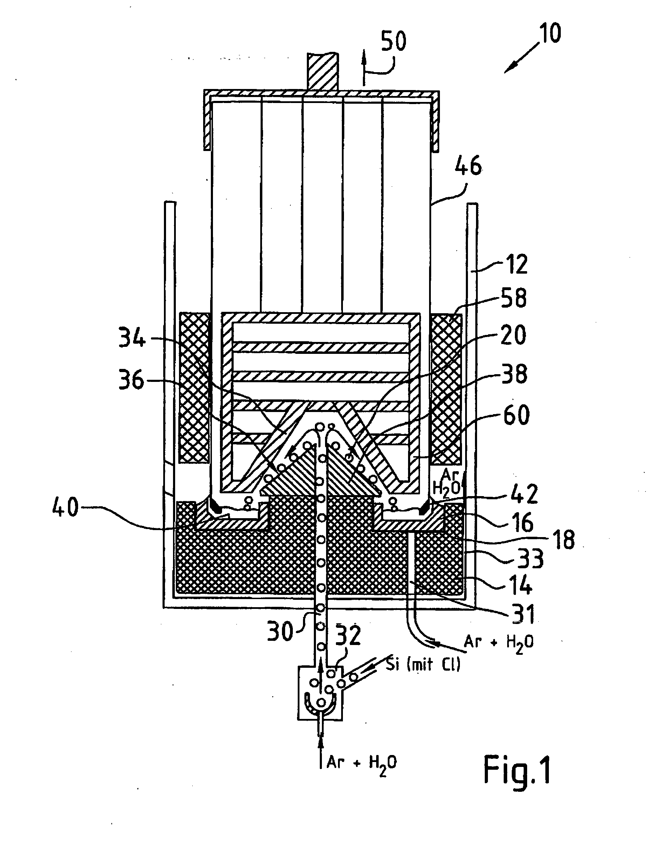

Der Fig. 1 ist ein prinzipieller Aufbau einer Anordnung zu entnehmen, mit der Silicium nach dem EFG (Edge-defined Film-fed Growth)-Prozess gezogen wird. Dabei können Rohre polygonaler oder zylindrischer Form oder Bänder hergestellt werden, wie dies nach dem EFG-Verfahren möglich ist.

Die Anordnung 10 weist entsprechend der Darstellung gemäß Fig. 1 ein auch als Rezipient zu bezeichnendes Gehäuse 12 auf, das eine Bodenisolierung 14 aufnimmt, in der ein ringförmiger Schmelztiegel 16 angeordnet ist. In dem Schmelztiegel 16, d. h. dessen ebenfalls eine Ringgeometrie aufweisenden Aufnahme 18 wird über eine nachstehend näher beschriebene Zuführeinrichtung Granulat 20 aufgeschmolzen. Dies kann z. B. über Widerstandsheizelemente oder induktiv erfolgen.

Das dem Schmelztiegel 16 bzw. dessen Aufnahme 18 zugeführte Granulat 20 weist eine kugelförmige, polygone oder staubförmige Morphologie auf. Bevorzugterweise ist jedoch eine Kugelform mit einer Kugeldurchmesserverteilung von 0,5 mm bis 5 mm, vorzugsweise zu 90 %, zwischen 0,8 mm und 3 mm zu nennen. Dabei sollte das aus Silicium bestehende Granulat 20 Chlor in einer Konzentration zwischen 5x10¹⁵ cm⁻³ und 1x10¹⁷ cm⁻³, bevorzugterweise mit einem Chlorgehalt bei 5x10¹⁶ cm⁻³ aufweisen. Entsprechendes kugelförmiges Granulat kann aus einem Wirbelschichtverfahren (fluidized bed reactor) unter Verwendung von Trichlorsilan oder anderen Chlorsilanen gewonnen werden.

Ebenfalls geeignet ist mechanisch klein gebrochenes Siliciumgranulat, gewonnen von grobstückigem Silicium aus einem Siemens-Prozess, unter Verwendung von Trichlorsilan oder anderen Chorsilanen, wobei die Siebkorngrößenverteilung zwischen mesh 0,5 und mesh 5 liegen sollte, vorzugsweise zu 90% zwischen mesh 1 und mesh 3. Insoweit wird auch auf das der US-A-5,077,028 zu entnehmende Verfahren verwiesen, deren Inhalt als Offenbarung gilt. In dem entsprechenden Verfahren lässt sich ein entsprechendes Granulat mit der zuvor angegebenen Korngrößenverteilung herstellen, die ein ausreichend schnelles Aufschmelzen beim EFG-Prozess innerhalb weniger Sekunden ermöglicht. Hierdurch ist sichergestellt, dass das in dem Granulat enthaltende Chlor in ausreichender Menge der Siliziumschmelze zugeführt wird.

Das Granulat 20 wird über eine den Boden des Gehäuses 12 sowie die Bodenisolierung 14 durchsetzende Leitung 30 mittels einer Einblaseinrichtung 32 eingebracht. Als Förderfluid wird ein Inertgas wie Argon mit beigemischtem Wasserdampf benutzt, wie nachstehend erläutert wird. Dabei trifft das Granulat 20 auf eine der Geometrie eines Schirmes gleichkommende Umlenkeinrichtung 34, um das Granulat 20 sodann entlang der Oberfläche 36 eines Kegelelementes 38 dem Schmelztiegel 16, d, h. dessen Aufnahme 18 zuzuführen. Durch eine entsprechende Ausgestaltung der Zuführeinrichtung erfolgt eine gleichmäßige Verteilung des Granulats 20 über den gesamten Umfang der ringförmigen Aufnahme 18.

Inertgas und beigemischter Wasserdampf können dem Innenraum des Rezipienten ferner über eine oder mehrere unterhalb des Schmelztiegels 16 mündende Leitungen 31 zugeführt werden, der von dem Inertgas-Wasserdampf-Gemisch umspült wird. Auch gelangt das Gemisch über zwischen der Bodenisolierung 14 und dem Gehäuse 12 vorhandene Spalte 33 in den Innenraum, insbesondere in den Bereich der Ziehzone, also in den Bereich zwischen Siliciumschmelze 40 und Spalt 42.

Im Außenumfangsbereich des Schmelztiegels 16 verläuft der eine Kapillarwirkung erzeugende Spalt 42, der mit Siliciumschmelze 40 über Schlitze oder Borungen verbunden ist, so dass die Schmelze 40 in den Spalt 42 fließt und aufgrund der Kapillarwirkung aus diesem kopfseitig heraustritt und einen Meniskus bildet. Der Meniskus erstarrt in seinem oberen Spitzenbereich beim Ziehen des Siliciums z. B. in Form eines Rohres 46, so dass entsprechend das Rohr 46 bzw. die erstarrten Abschnitte mittels einer Zugeinrichtung in Richtung des Pfeils 50 angehoben werden. Um die Menge des dem Schmelztiegel 16 zuzuführenden Granulats 20 exakt auf die Menge des abgezogenen Rohrabschnitts abzustimmen, kann die Zieheinrichtung 50 mit einer Wägezelle verbunden sein, deren Messwerte einem Regler zugeführt werden.

In gewohnter Weise wird der Einblaseinrichtung 32 das aufzuschmelzende Granulat 20 von einer Vorlage über eine Dosiereinrichtung zugeführt. Die Dosiereinrichtung ist über eine Wägezelle mit dem Regler verbunden, damit über die Einblaseinrichtung 32 dem Schmelztiegel 16 genau die Menge an aufzuschmelzendem Granulat zugeführt wird, die aus der Schmelze, d. h. dem kapillaren Spalt 42 abgezogen wird. Diese Menge wird mittels der mit der Zieheinrichtung 50 verbundenen Wägezelle ermittelt.

Entsprechend dem EFG-Prozess umfasst die Zieheinrichtung 50 einen Keimhalter als Formgebungsteil, der zu Beginn des Ziehvorganges einen im Ausfühmngsbeispiel der Geometrie des zu ziehenden Rohres entsprechenden Keim aufweist, der mit dem Meniskus kontaktiert wird.

Des Weiteren ist das Rohr 46 oberhalb des Schmelztiegels 16 von einer Isolation 58 bzw. Strahlungsschildern 60 umgeben, um die Abkühlung des Rohrs 46 gesteuert vornehmen zu können.

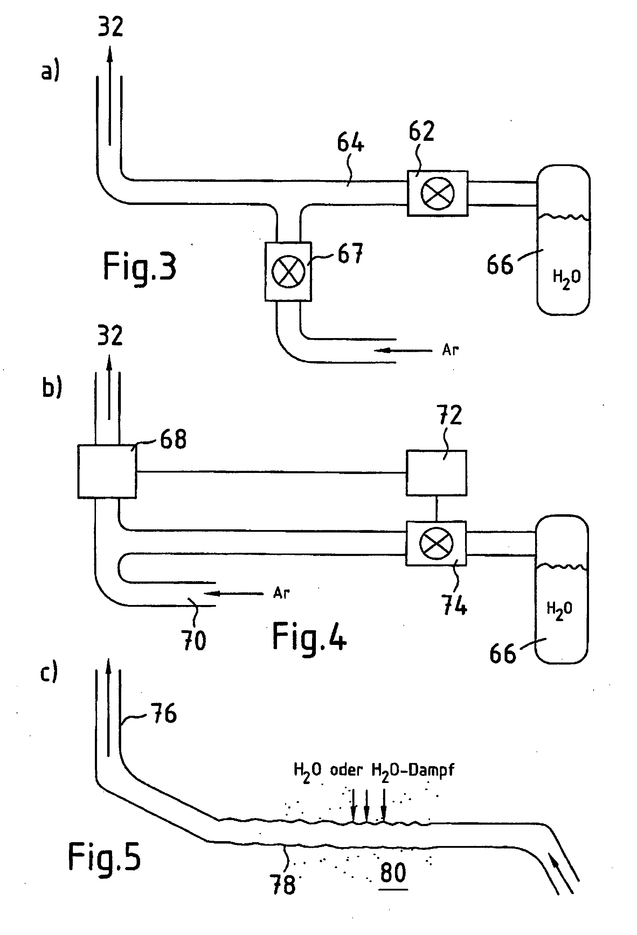

Zur Förderung des Granulats 20 wird erwähntermaßen im Wesentlichen ein Inertgas benutzt. Hierbei handelt es sich vorzugsweise um Argon. Erfindungsgemäß wird dem Inertgas Wasserdampf zugemischt, und zwar mit einem Anteil von 50 ppm bis 250 ppm. Das Inertgas selbst sollte einen Gesamtanteil an Sauerstoff bzw. Kohlenmonoxid bzw. Kohlendioxid von weniger als 20 ppm aufweisen. Das kontrollierte Zumischen des Wasserdampfs kann entsprechend der Darstellung in den Fig. 3 bis 5 auf verschiedene Weise geschehen.

So kann nach der Fig. 3 das Zumischen mittels eines Massendurchflussmessers 62, der in einer Leitung 64 angeordnet ist, die von einem Dampferzeuger 66 zu der Einblaseinrichtung 32 führt, erfolgen. Der gewünschte Wasserdampfgehalt im Inertgas ergibt sich dabei aus dem Verhältnis des eingestellten Wasserdampfdurchflusses und den unabhängig davon über ein Gerät 67 zu messenden Inertgasdurchfluss.

Entsprechend der Fig. 4 kann der Wasserdampfgehalt auch mittels eines Feuchtemessgerätes 68 bestimmt werden. Mit diesem wird der Wasserdampfgehalt in dem über eine Leitung 70 zugeführten Inertgas kontinuierlich oder zeitweise gemessen, um über einen Regler 72, der mit einem Regelventil 74 verbunden ist, die Wasserdampfeinmischung zu regeln.

Nach der Fig. 5 besteht die Möglichkeit, in eine in einer zu der Einblaseinrichtung 32 führenden Leitung 76 eine wasser- bzw. wasserdampfdurchlässige Membran 78 als Abschnitt der Leitung 76 einzusetzen, über den definiert Wasserdampf aus einem Reservoir 80 mit bekanntem Wassergehalt (z. B. reines Wasser) in den durch die Leitung 76 fließenden Inertgasstrom diffundieren kann.

Erfindungsgemäß erfolgt eine Wasserdampfeinmischung derart, dass der Anteil an Inertgas zwischen 50 ppm und 250 ppm liegt. Hierdurch wird erreicht, dass der absolute Sauerstoffgehalt in aus der Schmelze gezogenem kristallisierten Silicium zwischen 8x10¹⁵ cm⁻³ bis 4x16¹⁶ cm⁻³ liegt. Gleichzeitig wird durch das Beimischen von Wasserdampf erreicht, dass der Kohlenstoffgehalt im Vergleich zu bekannten Verfahren, bei denen zur Erhöhung des Sauerstofigehaltes Wasserdampf nicht eingeleitet wird, in der Größenordnung zwischen 5x10¹⁷ cm⁻³ und 3x10¹⁸ cm⁻³ bleibt. Dabei liegt der Kohlenstoff in Ausscheidung wie z. B. Siliciumcarbid vor, wobei der Kohlenstoff bis zu einem Kohlenstoffgehalt von in etwa 8x10¹⁷ cm⁻³ in Übersättigung gelöst vorliegt. Der Sauerstoff selbst liegt in gelöster Form in dem Silicium vor.

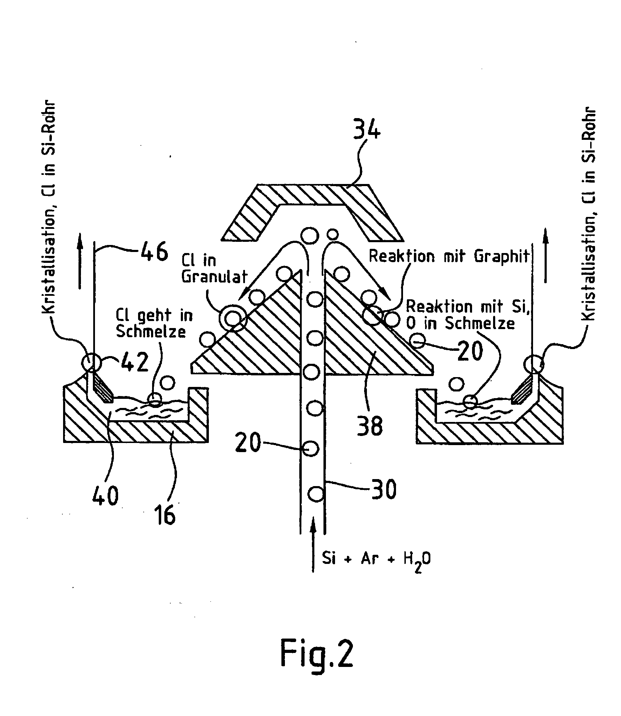

Die Fig. 2 verdeutlicht rein prinzipiell, wie das in dem Granulat 20 vorhandene Chlor bzw. der Sauerstoff des Wasserdampfs mit dem Silicium reagiert. Die im Granulat 20 vorhandenen Chloratome gehen in die Schmelze und verbleiben bei der Kristallisation in dem kristallisierten Silicium, das in dem erläuterten Ausfdhrungsbeispiel in Form eines Rohres aus der Schmelze gezogen wird.

Der Wasserdampf reagiert zum einen mit den aus Graphit bestehenden Einbauten in dem Rezipienten, also z. B. auch mit dem kegelförmigen Element 38. Ferner erfolgt eine Reaktion mit der Siliciumschmelze 40 selbst. Durch diese Reaktionen wird zum einen Sauerstoff in Silicium gelöst und zum anderen wird von dem Graphit Material in Form von SiC eingebracht.

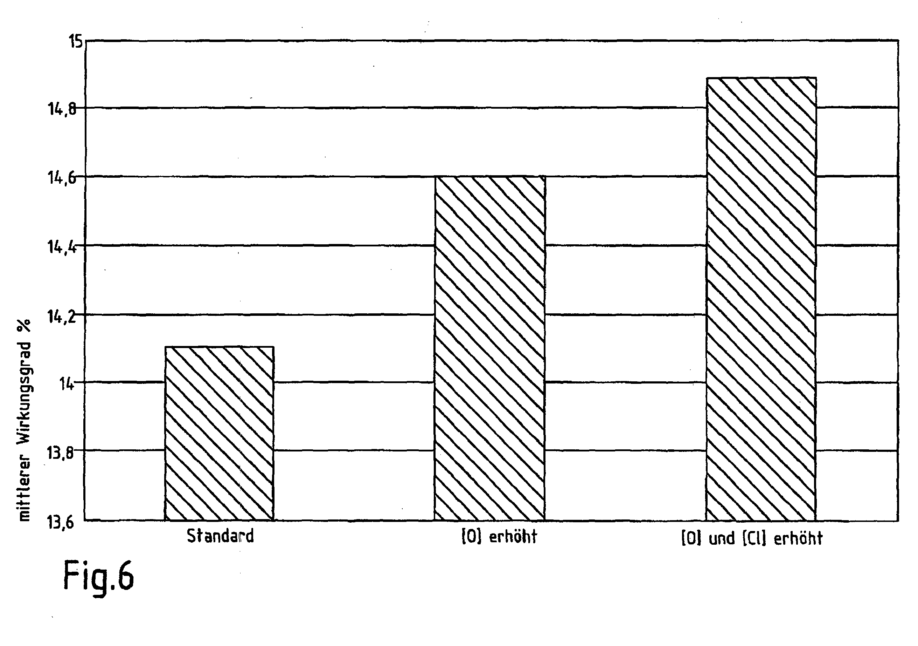

Durch gezielte Erhöhung des Sauerstoffgehalts in dem kristallisierten Silicium und dem erfindungsgemäß eingestellten Verhältnis von absolutem Kohlenstoffgehalt und absolutem Sauerstoffgehalt ergibt sich eine Erhöhung des Wirkungsgrades von Solarzellen, die aus nach dem zuvor beschriebenen EFG-Prozess hergestellten kristallisierten Silicium hergestellt werden. Dies wird anhand der Fig. 6 deutlich.

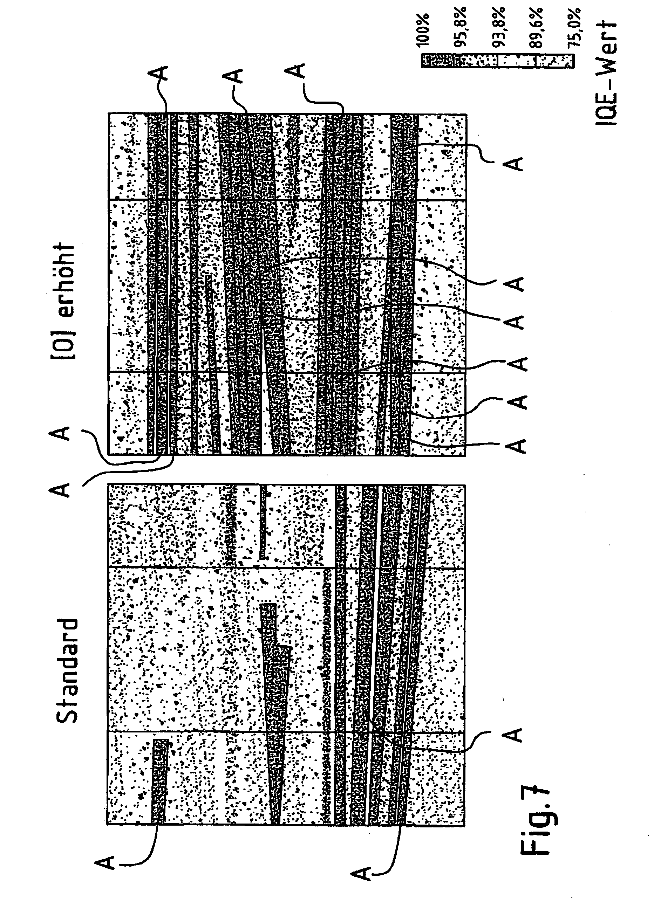

Die Fig. 7 zeigt, dass die interne Quanteneffizienz (IQE) bei Solarzellen erhöht wird, wenn das Silizium nach dem erfindungsgemäßen Verfahren mit erhöhtem Sauerstoffgehalt hergestellt wird. So erkennt man, dass die einen IQE-Wert von 100% aufweisenden und in den Darstellungen eine geringere Struktur aufweisenden Bereiche (rote Bereiche in der farbigen Darstellung, mit "A" gekennzeichnete Bereiche in der schwarz-weiß Darstellung) bei einer EFG-Solarzelle mit erhöhtem Sauerstoffgehalt und erfindungsgemäßem Verhältnis von Kohlenstoff- und Sauerstoffgehalt flächenmäßig größer sind als bei EFG-Solarzellen nach dem Stand der Technik.

### Bezugszeichenliste

- 10: Anordnung
- 12: Gehäuse
- 14: Bodenisolierung
- 16: Schmelztiegel
- 18: Aufnahmen
- 20: Granulat
- 30: Leitung
- 31: Leitung
- 32: Einblaseinrichtung
- 33: Spalt
- 34: Umlenkeinrichtung
- 36: Oberfläche
- 38: Kegelelement
- 40: Siliciumschmelze
- 42: Spalt
- 46: Rohr
- 50: Zieheinrichtung
- 58: Isolation
- 60: Strahlungsschild
- 62: Massendurchflussmesser
- 64: Leitung
- 66: Dampferzeuger
- 67: Gerät
- 68: Feuchtemessgerät
- 70: Leitung
- 72: Regler
- 74: Regelventil
- 76: Leitung
- 78: Membran
- 80: Reservoir

## Patentansprüche

1. Verfahren zum Herstellen kristallisierten Siliciums nach dem EFG-Prozess unter Verwendung eines Formgebungsteils, zwischen dem und einer Siliciumschmelze (40) kristallisiertes Silicium in einer Ziehzone wächst, wobei der Siliciumschmelze und/oder der Ziehzone ein Inertgas und zumindest Wasserdampf zugeführt wird, durch das der Sauerstoffgehalt in dem kristallisierten Silicium erhöht wird, **dadurch gekennzeichnet,**
**dass** dem Inertgas 50 ppm bis 250 ppm Wasserdampf zugemischt wird, wobei das Inertgas einen Gehalt an Sauerstoff, CO und/oder CO₂ von insgesamt weniger als 20 ppm enthält.

2. Verfahren nach Anspruch 1,
**dadurch gekennzeichnet,**
**dass** der Gehalt des Wasserdampfs in dem Inertgas mittels eines Massendurchflussmessers (62) oder eines Feuchtemessgerätes (68) eingestellt bzw. geregelt wird.

3. Verfahren nach Anspruch 1,
**dadurch gekennzeichnet,**
**dass** der Wasserdampf über eine wasser- bzw. wasserdampfdurchlässige Membran (78) aus einem Reservoir (80) bekannter Menge Wasser in das Inertgas diffundiert.

4. Verfahren nach zumindest einem der vorhergehenden Ansprüche,
**dadurch gekennzeichnet,**
**dass** chlorhaltiges Siliciumgranulat mit einem Chlorgehalt zwischen 1 ppmw und 50 ppmw, vorzugsweise in etwa 10 ppmw zur Bildung der oder von Siliciumschmelze aufgeschmolzen wird, wobei insbesondere das chlorhaltige Siliciumgranulat zum Nachchargieren verwendet wird.

5. Verfahren nach zumindest einem der vorhergehenden Ansprüche,
**dadurch gekennzeichnet,**
**dass** Granulat kugelförmiger Gestalt mit einer Kugeldurchmesserverteilung zwischen 0,5 mm und 5 mm aufgeschmolzen wird, wobei insbesondere Granulat kugelförmiger Gestalt aufgeschmolzen wird, bei dem in etwa 90% eine Kugeldurchmesserverteilung zwischen 0,8 mm und 3 mm aufweisen.

6. Kristallisiertes Silicium, das nach dem EFG-Verfahren hergestellt ist, insbesondere nach dem Verfahren nach zumindest einem der vorhergehenden Ansprüche, und wasserstoff Kohlenstoff und Sauerstoff enthält,
**dadurch gekennzeichnet,**
**dass** das kristallisierte Silicium einen Gesamtkohlenstoffgehalt C_{c} und einen Gesamtsauerstoffgehalt C_{O} im Verhältnis 1/50 ≤ C_{O}/C_{C} ≤ 1/500 sowie einen Chlorgehalt C_{Cl} mit 5x10¹⁵ cm⁻³ ≤ C_{CL} ≤ 1x10¹⁷ cm⁻³ aufweist, und dass der Sauerstoffgehalt C_{O} beträgt 8x10¹⁵ cm⁻³ ≤ C_{O} ≤ 4x10¹⁶ cm⁻³ und der Kohlenstoffgehalt C_{c} beträgt 5x10¹⁷ ≤ C_{C} ≤ 3x10¹⁸ cm⁻³,.

7. Kristallisiertes Silicium nach Anspruch 6,
**dadurch gekennzeichnet,**
**dass** sich der Gesamtkohlenstoffgehalt C_{c} zum Gesamtsauerstoffgehalt Cₒ in dem kristallisierten Silicium sich verhält wie in etwa 100:1.

8. Kristallisiertes Silicium nach Anspruch 6 oder 7,
**dadurch gekennzeichnet,**
**dass** der Sauerstoff in dem kristallisierten Silicium im Wesentlichen gelöst vorliegt und/oder dass der Kohlenstoff bis zu einem Kohlenstoffgehalt von in etwa 8x10¹⁷ cm⁻³ in Übersättigung gelöst vorliegt.

9. Kristallisiertes Silicium nach zumindest einem der Ansprüche 6 bis 8,
**dadurch gekennzeichnet,**
**dass** der Sauerstoffgehalt C_{O} in etwa 2x10¹⁶ cm⁻³ und/oder der Kohlenstoffgehalt C_{C} in etwa 2x10¹⁸ cm⁻³, beträgt.

10. Kristallisiertes Silicium nach zumindest einem der Ansprüche 6 bis 9,
**dadurch gekennzeichnet,**
**dass** das kristallisierte Silicium Kohlenstoff enthaltende Ausscheidungen enthält,
wobei insbesondere die Ausscheidungen zu 90 % eine Erstreckung kleiner als 50 nm aufweisen.

11. Kristallisiertes Silicium nach zumindest einem der Ansprüche 6 bis 10,
**dadurch gekennzeichnet,**
**dass** der Chlorgehalt in dem kristallisierten Silicium beträgt in etwa 5x10¹⁶ cm⁻³.

12. Wafer ausgeschnitten aus dem kristallisierten Silicium nach einem der Ansprüche 6 bis 11.

13. Verwendung des Wafers nach Anspruch 12 zur Herstellung einer Solarzelle.

## Claims

1. Method for producing crystallized silicon according to the EFG process by using a shaping part, between which and a silicon melt (40) crystallized silicon grows in a growth zone, whereby an inert gas and at least water vapor are fed into the silicon melt and/or growth zone, by means of which the oxygen content of the crystallized silicon is increased,
**characterized in**
**that** 50 ppm to 250 ppm of vapor water are added to the inert gas, whereby the inert gas has an oxygen, CO and/or CO₂ content of less than 20 ppm in total.

2. Method according to claim 1,
**characterized in**
**that** the water vapor content in the inert gas is adjusted, respectively controlled by means of a mass flow rate meter (62) or a moisture metering device (68).

3. Method according to claim 1,
**characterized in**
**that** the water vapor diffuses into the inert gas via a water and/or water vapor permeable membrane (78) from a reservoir (80) containing a known amount of water.

4. Method according to at least one of the preceding claims,
**characterized in**
**that** chlorine-containing silicon granules with a chlorine content between 1 ppmw and 50 ppmw, preferably approx. 10 ppmw, is melted to form the silicon melt or a silicon melt, wherein especially the chlorine-containing silicon granules are used for recharging.

5. Method according to at least one of the preceding claims,
**characterized in**
**that** granules of spherical shape with a sphere diameter distribution between 0.5 mm and 5 mm are melted, wherein especially granules of spherical shape are melted, of which approximately 90% have a sphere diameter distribution between 0.8 mm and 3 mm.

6. Crystallized silicon produced according to the EFG process, especially according to the method according to at least one of the preceding claims, and containing hydrogen, carbon and oxygen,
**characterized in**
**that** the crystallized silicon has a total carbon content C_{C}, and a total oxygen content CO in the ratio of 1/50 ≤ C_{O}/C_{C} ≤ 1/500 and a chlorine content C_{CL} of 5x10¹⁵ cm⁻³ ≤ C_{Cl} ≤ 1x10¹⁷ cm⁻³, and that the oxygen content C_{O} is 8x10¹⁵ cm⁻³ ≤ C_{O} ≤ 4x10¹⁶ cm⁻³, and the carbon content C_{C} is 5x10¹⁷ cm⁻³ ≤ C_{C} ≤ 3x10¹⁸ cm⁻³.

7. Crystallized silicon according to claim 6,
**characterized in**
**that** in the crystallized silicon the ratio of the total carbon content C_{C} to the total oxygen content C_{O} is about 100:1.

8. Crystallized silicon according to claim 6 or 7,
**characterized in**
**that** the oxygen in the crystallized silicon is essentially present in a diluted form and/or that the carbon is present up to a carbon content of about 8x10¹⁷ cm⁻³ in the form of an oversaturated solution.

9. Crystallized silicon according to at least one of claims 6 to 8,
**characterized in**
**that** the oxygen content C_{O} is approximately 2x10¹⁶ cm⁻³ and/or the carbon content C_{C} is approximately 2x10¹⁸ cm⁻³.

10. Crystallized silicon according to at least one of claims 6 to 9, **characterized in**
**that** the crystallized silicon contains carbon containing precipitates, wherein especially 90% of the precipitates have an extension smaller than 50 nm.

11. Crystallized silicon according to at least one of claims 6 to 10, **characterized in**
**that** the chlorine content in the crystallized silicon if of about 5x10¹⁶ cm⁻³.

12. Wafer cut out of the crystallized silicon according to one of the claims 6 to 11.

13. Use of the wafer according to claim 12 for producing a solar cell.

## Revendications

1. Procédé de fabrication de silicium cristallisé selon la méthode EFG en utilisant une pièce de façonnage, entre laquelle et une fonte de silicium (40) du silicium cristallisé croît dans une zone d'étirage, sachant qu'un gaz inerte et au moins de la vapeur d'eau sont ajoutés à la fonte de silicium et/ou à la zone d'étirage, ce qui génère une augmentation de la teneur en oxygène dans le silicium cristallisé, **caractérisé en ce**
**que** 50 ppm à 250 ppm de vapeur d'eau sont mélangés au gaz inerte, sachant que le gaz inerte présente une teneur en oxygène, CO et/ou CO₂ dans l'ensemble inférieure à 20 ppm.

2. Procédé selon la revendication 1,
**caractérisé en ce**
**que** la teneur en vapeur d'eau dans le gaz inerte est ajustée ou réglée à l'aide d'un débitmètre massique (62) ou d'un humidimètre (68).

3. Procédé selon la revendication 1,
**caractérisé en ce**
**que** la vapeur d'eau diffuse une quantité d'eau connue dans le gaz inerte par l'intermédiaire d'une membrane (78) perméable à l'eau ou à la vapeur d'eau à partir d'un réservoir (80).

4. Procédé selon au moins l'une des précédentes revendications,
**caractérisé en ce que** des granulés de silicium chlorés ayant une teneur en chlore entre 1 ppmw et 50 ppmw (ppm en poids), de préférence d'environ 10 ppmw, sont fondus pour la formation de ladite fonte ou d'une fonte de silicium, sachant que les granulés de silicium chlorés sont utilisés en particulier pour le rechargement.

5. Procédé selon au moins l'une des précédentes revendications,
**caractérisé en ce**
**que** les granulés de forme sphérique allant être fondus ont une distribution des diamètres des sphères entre 0,5 mm et 5 mm, sachant qu'il s'agit en particulier de granulés de forme sphérique, lesquels présentent approximativement à 90 % une distribution des diamètres des sphères entre 0,8 mm et 3 mm.

6. Silicium cristallisé fabriqué selon la méthode EFG, en particulier conformément au procédé selon au moins l'une des précédentes revendications, et qui contient de l'hydrogène, du carbone et de l'oxygène,
**caractérisé en ce**
**que** le silicium cristallisé présente une teneur totale en carbone C_{C} et une teneur totale en oxygène C_{O} dans un rapport tel que 1/50 ≤ C_{O}/C_{C} ≤ 1/500 ainsi qu'une teneur en chlore C_{Cl} telle que 5x10¹⁵ cm⁻³ ≤ C_{Cl} ≤ 1x10¹⁷ cm⁻³, et que la teneur en oxygène C_{O} est telle que 8x10¹⁵ cm⁻³ ≤ C_{O} ≤ 4x10¹⁶ cm⁻³ et la teneur en carbone C_{C} telle que 5x10¹⁷ ≤ C_{C} ≤ 3x10¹⁸ cm⁻³.

7. Silicium cristallisé selon la revendication 6,
**caractérisé en ce**
**que** le rapport entre la teneur totale en carbone C_{C} et la teneur totale en oxygène C_{O} dans le silicium cristallisé est approximativement égal à 100:1.

8. Silicium cristallisé selon la revendication 6 ou 7,
**caractérisé en ce**
**que** l'oxygène dans le silicium cristallisé est essentiellement sous forme dissoute et/ou que le carbone est sous forme dissoute en sursaturation jusqu'à une teneur en carbone d'environ 8x10¹⁷ cm⁻³.

9. Silicium cristallisé selon au moins l'une des revendications 6 à 8,
**caractérisé en ce**
**que** la teneur en oxygène C_{O} s'élève à approximativement 2x10¹⁶ cm⁻³ et/ou la teneur en carbone C_{C} à approximativement 2x10¹⁸ cm⁻³.

10. Silicium cristallisé selon au moins l'une des revendications 6 à 9, **caractérisé en ce**
**que** le silicium cristallisé contient des dépôts contenant du carbone, sachant qu'en particulier les dépôts présentent à 90 % une extension inférieure à 50 nm.

11. Silicium cristallisé selon au moins l'une des revendications 6 à 10, **caractérisé en ce**
**que** la teneur en chlore dans le silicium cristallisé s'élève approximativement à 5x10¹⁶ cm⁻³.

12. Plaquette découpée dans le silicium cristallisé selon l'une des revendications 6 à 11.

13. Utilisation de la plaquette selon la revendication 12 pour la fabrication d'une cellule solaire.
